(19) Europäisches Patentamt

European Patent Office

Office européen des brevets

(11) **EP 0 855 856 A1**

(12) **EUROPEAN PATENT APPLICATION**

(43) Date of publication:
29.07.1998 Bulletin 1998/31

(51) Int. Cl.$^6$: **H05K 13/00**

(21) Application number: 97300521.8

(22) Date of filing: 28.01.1997

(84) Designated Contracting States:
**BE CH DE FR GB LI NL**

(71) Applicant: **ORBOTECH LTD**
**Yavne 70651 (IL)**

(72) Inventors:
- **Teichman, Eyal**
  **Tel Aviv 62283 (IL)**
- **Altman, Israel**
  **Kiriat Ono 55422 (IL)**
- **Negry, Shabtay**
  **Givat Shmuel 54056 (IL)**

- **Lev, Nimrod**
  **Ganey Yehuda 56905 (IL)**
- **Hadasi, Tal**
  **Rakefet 20175 (IL)**
- **Linyado, Yitzhak**
  **Rehovot 76208 (IL)**

(74) Representative:
**Caldwell, Judith Margaret et al**
**David Keltie Associates,**
**12 New Fetter Lane**
**London EC4A 1AP (GB)**

(54) **Method and system for continuously processing successive workpieces along a production line**

(57) A system (10) for continuously processing successive workpieces along a production line having a loader (11) for loading workpieces (12) on to a main conveyor (13) for conveying through a workstation (14) and an unloader (15) for unloading the workpiece after processing. The loading and unloading are achieved without disturbing the main conveyor during operation of the workstation so as not to vibrate the workpiece during operation of the workstation. According to one embodiment, the workpiece is a printed circuit board and the workstation is an optical inspection system (14). Alternative transfer mechanisms allow for the workpiece to be conveyed by the main conveyor during inspection or by an independent carriage.

F i g . 1 f

Printed by Xerox (UK) Business Services
2.16.3/3.4

## Description

## BACKGROUND OF THE INVENTION

The present invention relates to a method for conveying flat workpieces to and through a processing machine and a conveying system therefor, which is particularly useful with a processing machine requiring a precise positioning of the workpiece during processing.

Continuous mass production of various workpieces has required development of conveying systems capable of transporting a stream of workpieces from a supply stack to a return stack through a working station for processing operations, for example cutting, recording, inspecting, or the like. It is commonly a necessary condition for most processing operations that the workpiece be precisely positioned. Additionally, it is often the case that either the workpiece should be firmly retained in place on the working table during processing, or alternatively sliding movement of the workpiece relative to the surface of the table should be suitably guided.

However, providing a separate specially equipped working table and transferring the workpieces from the conveying system on to the working table imposes additional loading, positioning and unloading operations thus slowing down the production. Furthermore, the consequent additional manipulations may cause damage to the workpieces and requires additional equipment which occupies considerable floor space.

## SUMMARY OF THE INVENTION

It is a principal object of the present invention to provide a conveying method and system enabling a stream of workpieces to be transported progressively whilst allowing for one of the workpieces to be processed without disturbance during the conveyance of other workpieces.

According to a broad aspect of the invention there is provided a method for continuously processing successive workpieces along a production line having a loading means for loading workpieces on to a conveying means for conveying through a processing means and an unloading means for unloading a processed workpiece,

CHARACTERISED BY THE STEPS OF:

(a) loading an operational workpiece on to a feed means,
(b) transferring the operational workpiece from the feed means to the conveying means,
(c) conveying the operational workpiece through the processing means for performing a desired operation thereon,
(d) loading a successive workpiece on to the feed means,
(e) after said operation has been performed, unloading the operational workpiece from the conveying means, and
(f) repeating steps (b) to (e), as required, in respect of successive workpieces.

According to another aspect of the invention, there is provided a system for continuously processing successive workpieces along a production line having a loading means for loading workpieces on to a conveying means for conveying through a processing means and an unloading means for unloading a processed workpiece,

CHARACTERISED IN THAT:

(a) a feed means independent of the conveying means receives a workpiece from the loading means without disturbing the conveying means, and
(b) a transfer means is provided for transferring the operational workpiece from the feed means to the conveying means prior to processing of the workpiece, and
(c) the unloading means is coupled to the conveying means for unloading the operational workpiece from the conveying means after processing so as to allow subsequent unloading without disturbing the conveying means.

The unloading means may be a working table of a further processing station and/or may be also provided with one or more conveying mechanisms.

More specifically, the invention is useful in conjunction with a station for optical inspection of printed circuit boards (PCBs) having an artwork thereon and is therefore described below with respect to this application. Preferably, in such an embodiment, the conveying means is driven by a drum which itself functions as a support surface for supporting the PCB during optical inspection.

## BRIEF DESCRIPTION OF THE DRAWINGS

These and other features and advantages of the present invention will become apparent from the ensuing detailed description of the preferred embodiments, given by way of example only, when taken in conjunction with the drawings, in which:

**Fig. 1a to 1f** shows schematically a conveying system in accordance with a first embodiment of the present invention during successive operational phases;
**Figs. 2a and 2b** are a flow diagram showing the principal steps for operating the system illustrated in Figs. 1a to 1f;
**Fig. 3** is a simplified flow diagram showing fundamental operating principles of the invention;
**Fig. 4a to 4h** shows schematically a conveying system in accordance with a second embodiment of the present invention during successive operational phases;

**Fig. 5** is a flow diagram showing the principal steps for operating the system illustrated in Figs. 4a to 4h;

**Fig. 6a** shows schematically a perspective view of a detail of a conveying system constructed in accordance with the second embodiment of the present invention and having a main conveyor;

**Figs. 6b and 6c** show schematically details of a cross-section taken through the line $\overline{A\text{-}A}$ in Fig. 6a;

**Fig. 7a** shows a detail of the main conveyor illustrated in Fig. 4a;

**Fig. 7b and 7c** show schematically operative and inoperative positions of an elevation mechanism for use with a support platform of the main conveyor illustrated in Fig. 7a;

**Fig. 8a and 8b** show the disposition of the workpiece relative to the main conveyor during operative and inoperative positions of the elevation mechanism; and

**Fig. 9** is a pictorial representation of a PCB conveying system operating in accordance with the principles of the invention.

## DETAILED DESCRIPTION OF PREFERRED EMBODIMENTS

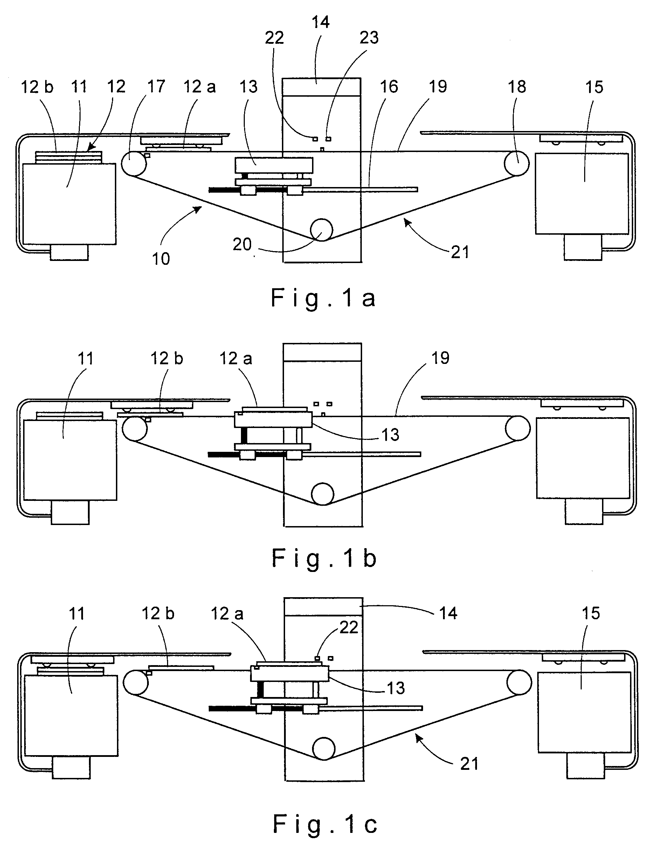

Figs. 1a to 1f show successive stages in a conveying system designated generally as 10 according to a first embodiment of the invention. The conveying system 10 comprises a loader 11 (constituting a loading means) for loading an uppermost PCB 12a in a stack of PCBs 12 (constituting workpieces) on to a conveyor 13 (constituting a conveying means) for conveying the PCB 12a through an inspection station 14 (constituting a processing means). After inspection by the inspection system 14, the inspected PCBs are then transferred to an unloader 15 (constituting an unloading means) from which they may, if desired, be transferred to another processing system (not shown) downstream of the inspection system 14 for further processing.

In the embodiment shown in Figs. 1a to 1f of the drawings, the conveyor 13 is in the form of a carriage adapted for translational movement along a guide rail 16 and also adapted for vertical up and down movement for reasons which will become apparent in the following description.

Disposed upstream and downstream of the inspection system 14 are rollers 17 and 18 for supporting a conveyor belt 19 which is further supported at a lower midpoint thereof by a third roller 20. The conveyor belt 19 in combination with the rollers 17, 18 and 20 constitute a feeder 21 for feeding the PCB 12a to the conveyor 13 prior to inspection thereof and for feeding the inspected PCB to the unloader 15 after inspection thereof. In order to determine when a PCB on the conveyor 13 has reached the inspection station 14 and also when it has completely passed therethrough, there are provided a pair of sensors 22 and 23 which respectively detect when a leading edge of the PCB 12a on the conveyor 13 has reached the inspection system 14 and when a trailing edge of the PCB 12a on the conveyor 13 has passed therethrough.

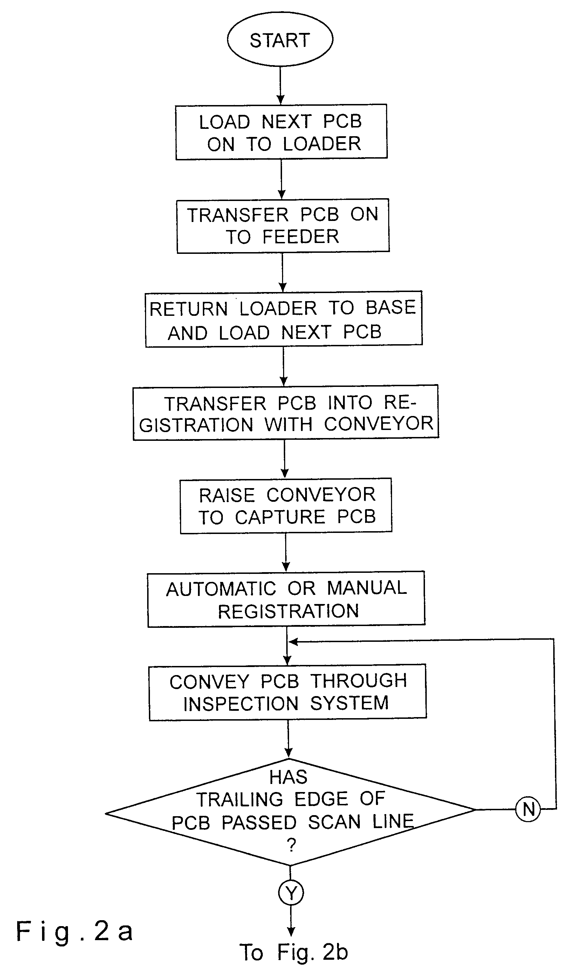

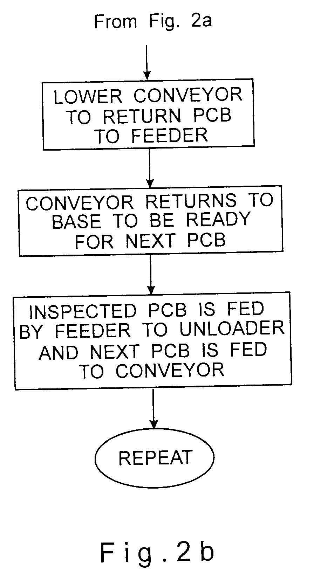

Figs. 2a and 2b are a flow diagram showing the principal operating steps of the system 10 which will now be described with particular reference to the various stages of operation thereof shown in Figs. 1a to 1f of the drawings. Fig. 1a shows a first stage of operation wherein a first, topmost PCB 12a in a stack of PCBs 12 is extracted by the loader 11 and is transported by the loader 11 to the conveyor belt 19 of the feeder 21. Rotation of the rollers 17 and 18 in a clockwise direction transports the conveyor belt 19 thereby feeding the first PCB 12a towards the inspection system 14. During this operation, the area on the conveyor belt 19 where the first PCB 12a was fed by the loader 11 is now freed so as to be able to accommodate a second, successive PCB 12b from the stack 12. Therefore, the carriage of the loader 11 is now returned to base (i.e. its initial loading position) so as to extract the second PCB 12b from the stack 12 and this is then placed on the conveyor belt 19 as shown in Fig. 1b of the drawings. Whilst this happens, the first PCB 12a is brought into registration with the conveyor 13. At this point, the conveyor 13 is lifted so as to lift the first PCB 12a from the conveyor belt 19 in the feeder 21 to the conveyor 13. Thus, the first, topmost PCB 12a is located on the conveyor 13 whilst a second, successive PCB is accommodated on the feeder 19.

Each of the operating steps is shown sequentially in Figs. 1a to 1f of the drawings. Thus, in Fig. 1a, the first PCB 12a has just been placed on the feeder 21 whilst the conveyor 13 downstream of the first PCB 12a is in its low position.

Fig. 1b depicts the next stage of operation when the feeder 21 has brought the first PCB 12a into overlapping registration with the conveyor 13 and the second, successive PCB 12b has been placed by the loader 11 on to the feeder 21. Whilst in this position, the conveyor 13 is then raised so as to lift the first PCB 12a from off the conveyor belt 19 on to the carriage constituting the conveyor 13.

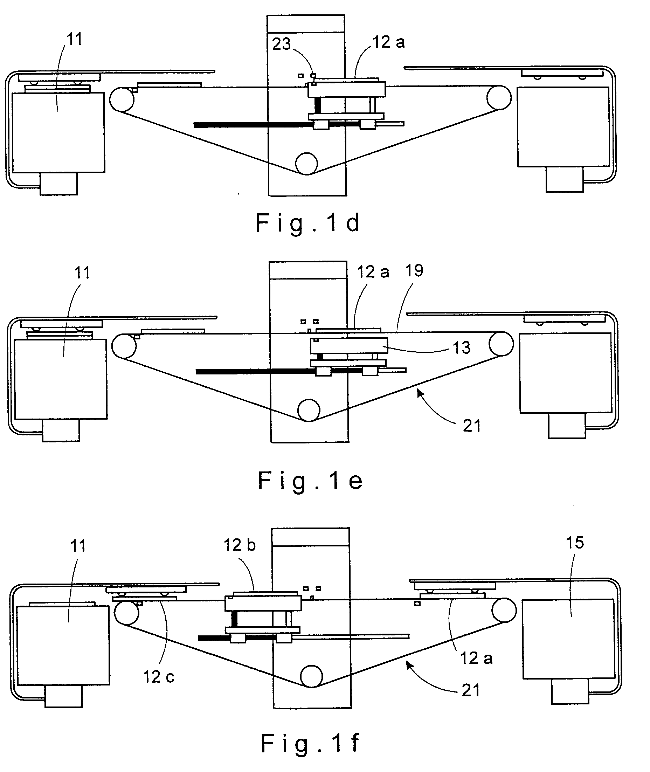

In Fig. 1c, the second, succeeding PCB 12b remains at the end of the feeder 21 upstream of the inspection station 14, whilst the conveyor 13 starts to move towards the unloader 15. During such movement of the conveyor 13, the feeder 21 being physically separate from the conveyor 13 does not impart any disturbance to the conveyor 13 which might impair the inspection process. Movement of the feeder 21 is inhibited during translation of the conveyor 13 from the position shown in Fig. 1c so as to allow the first PCB 12a to complete inspection, whereupon the conveyor 13 is returned to the feeder 21 to acquire the next PCB 12b. If the feeder 21 were not inhibited in such manner, then the next PCB 12b would be conveyed towards the conveyor 13 and would possibly either collide with the carriage of the conveyor 13 which is at this stage in its elevated position thus protruding above the feeder 21; or alternatively might be conveyed beyond the point from which it is to be transferred from the belt of the feeder 21 on to the carriage of the conveyor 13. In order to avoid such possibility, the feeder 21 is inhibited from the moment the leading edge of the first PCB 12a on the conveyor 13 is aligned with the sensor 22 and up to the position shown in Fig. 1d wherein a trailing edge of the PCB 12a is aligned with the sensor 23.

At this point, as shown in Fig. 1e, the conveyor 13 is lowered whereupon the first PCB 12a is released on to the conveyor belt 19 of the feeder 21 whereupon, as shown in Fig. 1f, the conveyor 21 is re-started so as to conveyor the first PCB 12a towards the unloader 15 whilst bringing the second, successive PCB 12b into overlapping relationship with the conveyor 13. The upstream end of the conveyor 21 having been thus vacated, the third, successive PCB 12c is now loaded by the loader 11 on to the feeder 21 and the whole cycle is repeated.

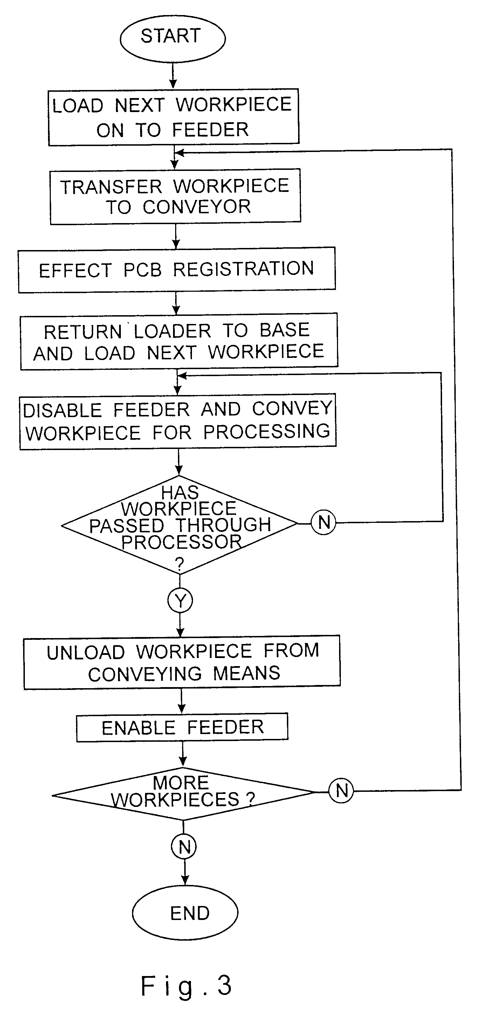

Fig. 3 shows the principal operating steps which define the essential features of the invention and which are common to all embodiments thereof. Thus, successive workpieces are loaded on to a feeder whereupon workpieces are successively transferred to a conveyor. At the same time, or shortly thereafter, the loader returns to base for loading the next workpiece. The feeder is now disabled and the workpiece on the conveyor is conveyed for processing. After processing, the processed workpiece is transferred back to the feeder which is now enabled and the cycle repeated, as required.

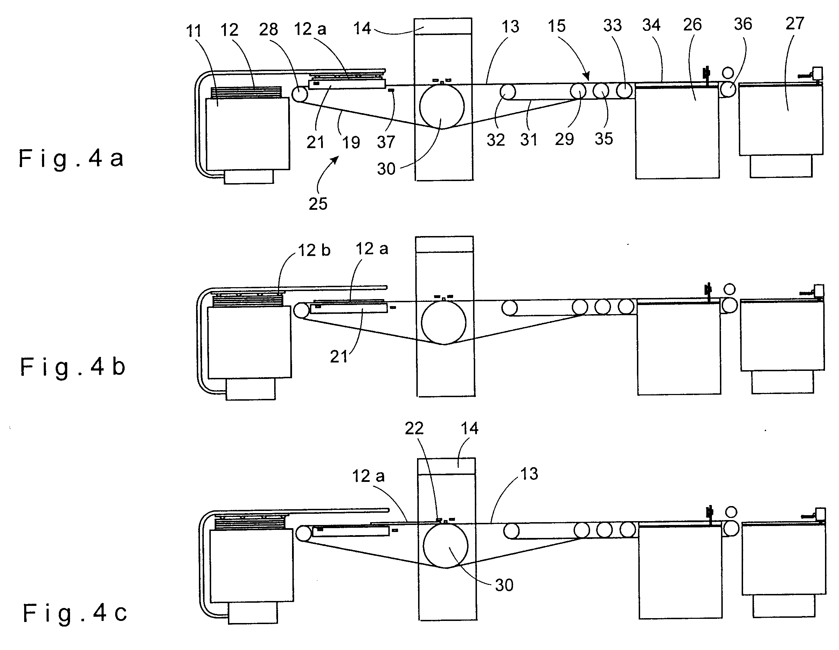

Figs. 4a to 4h show successive stages in a conveying apparatus designated generally as 25 according to a second embodiment of the invention. Those components of the apparatus 25 which are common to all embodiments will, for the sake of consistency, be identified by the same reference numerals. Thus, the apparatus 25 comprises a loader 11 for loading an uppermost PCB 12a in a stack of PCBs 12 on to a conveyor 13 for conveying the PCB 12a through an inspection station 14. After inspection, the inspected PCBs are then transferred to an unloader 15 which unloads the PCBs from the conveyor 13 for onward transfer to a downstream marking station 26 whereupon the marked PCBs are then transferred to a collection station 27. The conveyor 13 comprises freely rotatable rollers 28 and 29, the conveyor 13 itself being driven by means of a central drum 30 operated by a suitable drive means (not shown) connected to an operating shaft thereof.

The unloader shown generally as 15 also comprises a conveyor belt 31 which is supported at opposite ends thereof by rollers 32 and 33. Likewise, a third conveyor 34 is supported at opposite ends thereof by respective rollers 35 and 36 for conveying an inspected PCB from the unloader 15 through the marking station 26 and on to the collection station 27. Associated with the feeder 21 is a sensor 37 for detecting when a PCB on the conveyor 13 has completely cleared the feeder 21, thus permitting the feeder 21 to receive a successive PCB from the loader 11.

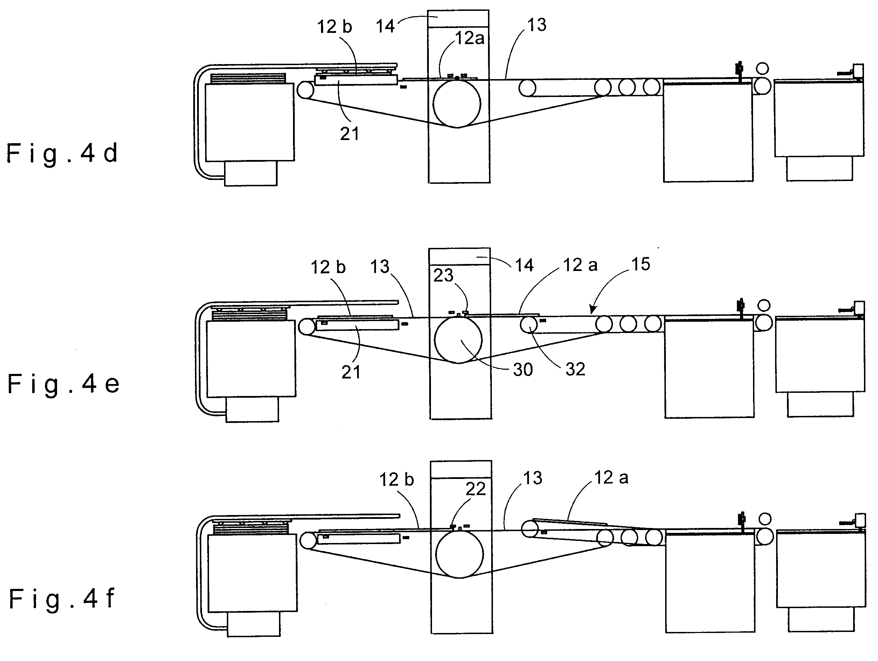

As will be explained in greater detail below, the unloader 15 is adapted for tilting movement such that the upstream roller 32 thereof may be raised above the level of the conveyor 13. By such means, as will be explained with particular reference to Fig. 4f of the drawings, a PCB on the conveyor 13 may be transferred to the unloader 15.

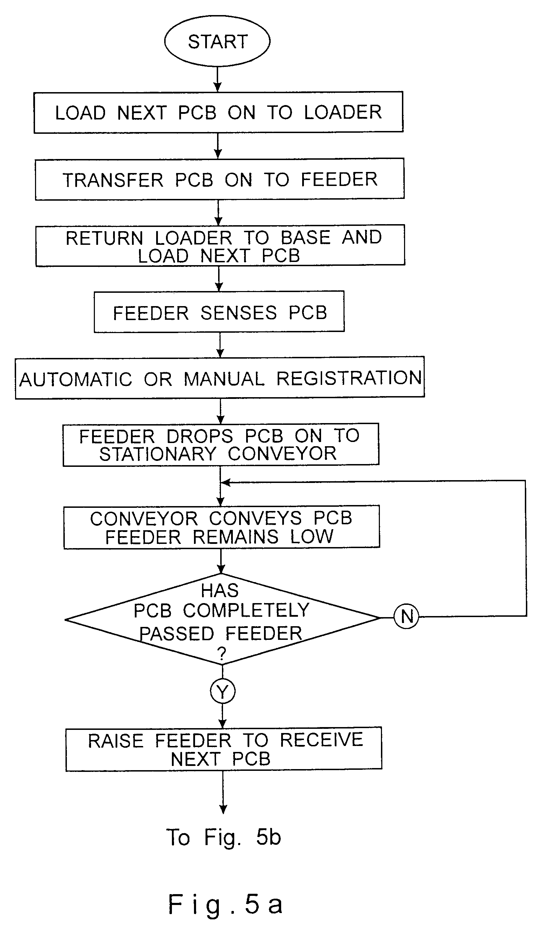

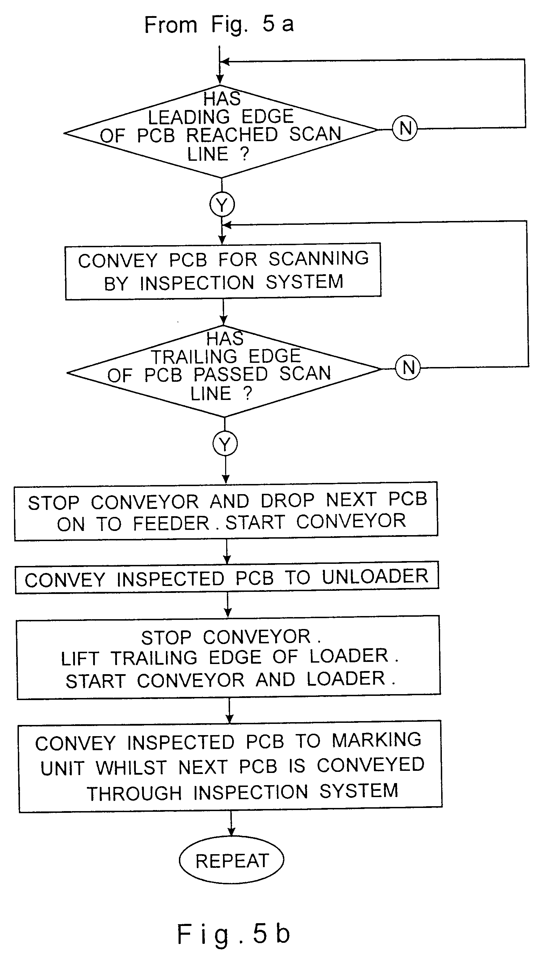

Figs. 5a and 5b are a flow diagram showing the principal operating steps of the system 25 which will now be described with particular reference to the various stages of operation thereof shown in Figs. 4a to 4h of the drawings. In order to avoid any possibility of confusion with the first embodiment shown in Figs. 1a to 1f of the drawings, it is to be noted at the outset that the conveyor belt supported on the rollers 28 and 29 constitutes the conveyor 13 whilst the feeder, also shown as 21 for consistency with the embodiment, is a platform adapted for up and down vertical movement so as to lift a PCB from off the conveyor 13; or, alternatively, to drop a PCB thereon, as required.

Operation of the system 25 is as follows. Initially, the feeder 21 is in an elevated position as shown in Fig. 4a and the loader 11 loads a first, topmost PCB 12a from the stack of PCBs 12 on to an upper surface of the feeder 21. As shown in Fig. 4b, the feeder 21 is now lowered so that its upper surface is beneath an upper surface of the conveyor 13, whereupon the first PCB 12a is transferred from the feeder 21 to the conveyor 13. During this operation, the loader 11 is returned to base so as to load the second, successive PCB 12b. The PCB 12a is pre-registered with the conveyor 13 whilst still on the feeder 21 so that it maintains the correct registration upon being deposited on to the conveyor 13. By such means, the need for separate registration of the PCB 12a whilst on the conveyor 13 is avoided.

As shown in Fig. 4c, the conveyor 13 is now driven by the drum 30 so as to convey the first PCB 12a towards the inspection station 14 until a leading edge of the PCB 12a reaches the first sensor 22.

As shown in Fig. 4d, further motion of the conveyor 13 conveys the first PCB 12a through the inspection station 14 and, in so doing, evacuates the feeder 21. The empty feeder 21 is now raised as shown in Fig. 4d so as to receive the second, successive PCB 12b, during which time the conveyor 13 is disabled so that movement of the feeder 21 causes no disturbance to the first PCB 12a passing through the inspection station 14.

As shown in Fig. 4e, the drum 30 is now rotated so as to transport the first PCB 12a through the inspection station 14 along the conveyor 13 until the trailing edge of the PCB 12a reaches the sensor 23, thus indicating that inspection has been completed. The relationship between the length of the PCB 12a and the distance between the drum 30 and the upstream roller 32 of the unloader 15 is such that the leading edge of the PCB 12a at least slightly overlaps the upstream roller 32. The feeder 21 is now lowered so as to transfer the second, successive PCB 12b on to the conveyor 13 for conveying through the inspection station 14.

As shown in Fig. 4f, the second, successive PCB 12b is conveyed towards the inspection station 14: this continuing until the leading edge of the second PCB 12b reaches the sensor 22. The conveyor 13 is now disabled so that the second, successive PCB 12b remains stationary and the upstream roller 32 of the unloader 15 is tilted so that the upstream roller 32 is elevated, whereby further rotation of the upstream roller 32 causes the first PCB 12a to be unloaded without disturbing the conveyor 13 since is physically separate therefrom.

As shown in Fig. 4g, whilst the first PCB 12a is being thus unloaded by the unloader 15, the drum 30 is now re-started so as to enable the conveyor thereby conveying the second PCB 12b through the inspection station 14 until the trailing edge thereof clears the feeder 21 as shown by the sensor 37. Thereupon the feeder 21 is raised so as to receive a third, successive PCB 12c from the loader 11.

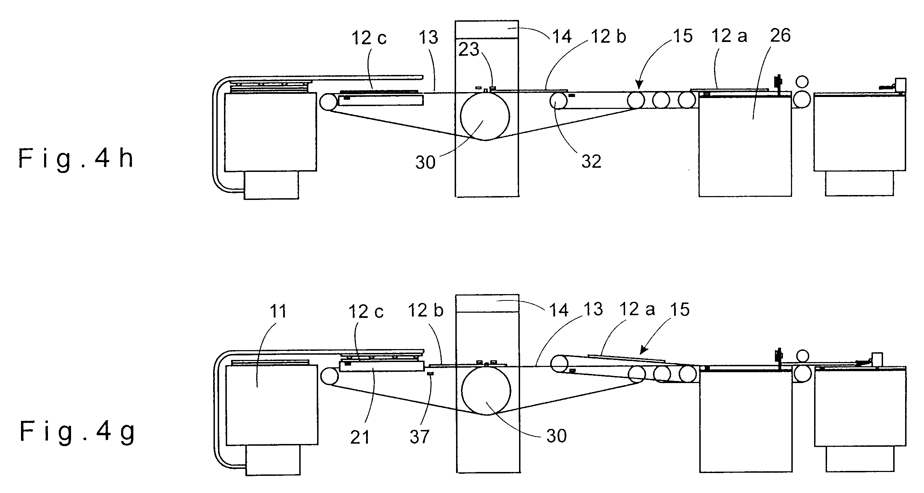

Finally, as shown in Fig. 4h, the feeder 21 is lowered so as to transfer the third, successive PCB 12c on to the conveyor 13; the upstream roller 32 of the unloader 15 is lowered into its normal operating position and the drum 30 is driven so as to enable the conveyor 13. The conveyor 13 now conveys the first PCB 12a on to the marking station 26 whilst, at the same time, the second PCB 12b is conveyed through the inspection station 14 and the third PCB 12c is partially conveyed towards the inspection station 14.

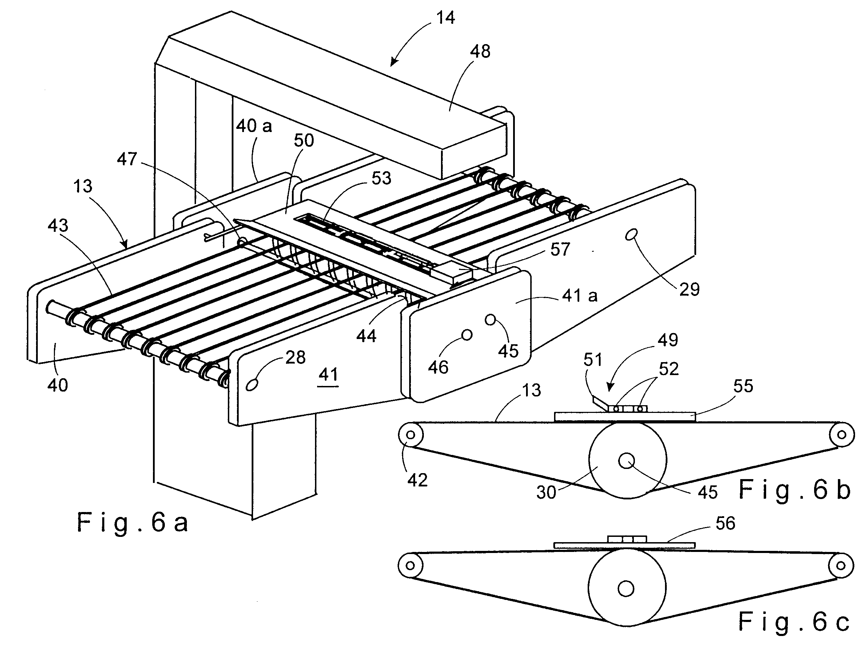

Having now described the system functionally, details thereof will now be described with particular reference to Figs. 6a to 8c of the drawings.

Fig. 6a shows a detail of the conveyor 13 having a pair of side frames 40 and 41 supporting at opposite ends thereof rollers 28 and 29 each supporting at spaced apart intervals pulleys 42 for supporting respective conveyor belts 43. The belts 43 may be Round Belts PN DIA-7 (GREEN) commercially available from MULON Ltd. As noted above, the conveyor belts 43 are supported at opposite ends by the rollers 28 and 29 and are supported, under tension, at a mid-location thereof by the drum 30. The drum 30 is itself supported within opposite side frames 40a and 41b which are independent of the side frames 40 and 41 of the conveyor 13. An outer surface of the drum 30 is formed with a plurality of spaced apart parallel circumferential recesses 44 for slidably accommodating therein respective ones of the conveyors belts 43. By such means, the drum 30 not only conveys the PCB 12a through the inspection station 14, but also acts as a supporting surface for supporting thereon each PCB 12a during inspection. Preferably, the outer surface of the drum 30 is provided with a rubber coating so as to increase friction between the supporting surface of the drum 30 and the PCB 12a and thus prevent movement of the PCB 12a during inspection.

The drum is driven via a central drive shaft 45 directly coupled to a motor, such as Direct Drive Torque Motor TM 5125V-148-031 commercially available from Verwitron Ltd., U.S.A. The rotation of the drum 45 is controlled by an encoder, such as Rotary Laser Encoder R-11 commercially available from Canon Europe NV. In addition to the central drive shaft 45 of the drum 30, there is also provided an eccentric drive 46 which is eccentrically mounted in bearings 47 supported within the respective side frames 40a and 41a so as to allow the drum 30 to be vertically displaced within the side frames 40a and 41a so as thereby to raise the upper surface of the PCB 12a during inspection and thus ensure that its distance from an optical imager shown generally as 48 is maintained. By such means, accurate focus of the upper surface of the inspected PCB 12a may be maintained regardless of variations in the thickness of the PCB 12a which can range from 0.05 mm to 5 mm.

The PCB 12a being inspected is guided through the inspection system 14 by means of a guiding mechanism shown generally as 49 in the form of a cover 50 whose leading edge 51 is slightly upraised so as to allow an advancing PCB to pass underneath the raised leading edge 51 and thus ensure its unimpeded passage through the inspection system 14. To aid passage of the PCB through the guiding mechanism 49, there is provided a pair of freely rotatable roller bearings 52 for providing rolling contact with an upper surface of the PCB. The cover 50 is provided with an elongated aperture 53 defining a scan line directly beneath the imaging optics 48.

The operation of the guiding mechanism 49 is shown schematically in Figs. 6b and 6c of the drawings in respect of PCBs 55 and 56 having different widths. In operation, the drum 30 is lowered before the PCB 55 or 56 reaches the guiding mechanism 49 so as to provide adequate clearance between the guiding mechanism 49 and the upper supporting surface of the drum 30 regardless of the thickness of the PCB. The PCB 55 or 56 passes under the upraised leading edge 51 of the guiding mechanism 49 whereupon the drum 30 is raised until the PCB 55 or 56 is properly supported on the upper surface of the drum 30 beneath the cover 50 with the upper surface of the PCB 55 or 56 substantially coplanar with a lower surface of the cover 50. In order to guard against the possibility, during production, that the leading edge of a PCB might escape through the aperture 53 of the cover 50, there is provided an alarm sensor 57 at one end of the elongated aperture 53 for detecting a PCB located on top of the cover 50 and providing a suitable alarm signal. The alarm sensor 57 may be, for example, an optical sensor such as FZ5IL Sensor Through-Beam Transmitter & Receiver commercially available from Keyence Lead Electric Corp.

Construction and operation of the alarm sensor 57 are not in themselves features of the present invention and are therefore not specifically described.

It will thus be clear that each of the PCBs in the stack 12 is conveyed by means of the conveyor belts 43 through the inspection system 14. As noted above, it is a principal feature of the invention that successive PCBs are placed on to the conveyor 13 in such a manner as not to cause vibrations of the conveyor 13 or any other disturbance thereto which might impair the accuracy of the optical inspection.

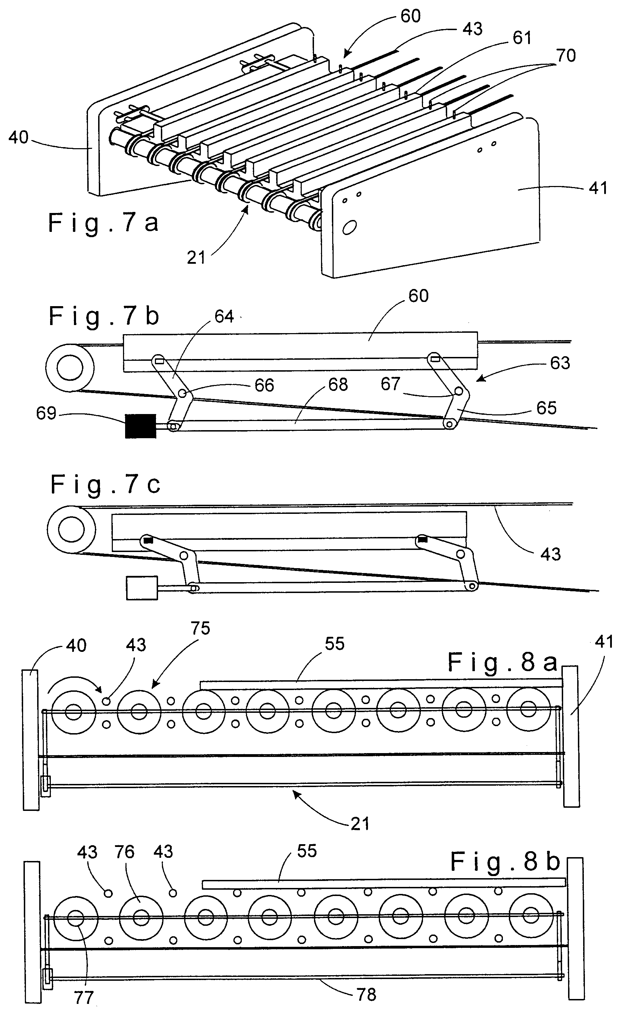

Fig. 7a is a pictorial representation of the feeder 21 which operates in conjunction with the conveyor 13 so as to allow the desired transfer of successive PCBs from the loader 11 to the conveyor 13. Thus, it is to be noted that the feeder 21 has a supporting surface shown generally as 60 in the form of spaced apart turrets 61 such that when the feeder 21 is in an elevated position (as shown in Fig. 7a) the turrets 61 are accommodated between adjacent conveyor belts 43. The feeder 21 is lowered and raised by means of a mechanical linkage 63 having upper and lower operating positions shown, respectively, in Figs. 7b and 7c of the drawings.

Thus, the linkage mechanism 63 comprises a pair of parallel links 64 and 65 hingedly supported on respective pivot axes 66 and 67 over which are mounted at opposite ends thereof within the side frames 40 and 41 of the feeder 21. Upper ends of the links 64 and 65 are hingedly connected to the support surface 60 of the feeder 21 whilst lower ends of the links 64 and 65 are hingedly connected to a strut 68 which is itself coupled to a piston 69 adapted for horizontal to-and-fro movement of the strut 68 so as thereby to raise or lower the support surface 60 of the feeder 21, as required. Specifically, as noted in Figs. 7a and 7b, when the feeder 21 is in its elevated position, the turrets 61 protrude through the gaps between adjacent conveyor belts 43, whilst in its lower position, as shown in Fig. 7c, the supporting surface 60 of the feeder 21 lies beneath the conveyor belts 43. Thus, a PCB is transferred from the loader 11 (Fig. 4a) to the conveyor 13 by first disposing the PCB on to the supporting surface 60 of the feeder 21 when the feeder 21 is in its elevated position; whereby, lowering the feeder 21 to the position shown in Fig. 7c, causes the PCB on the supporting surface 60 of the feeder 21 to be transferred to the conveyor belts 43 of the conveyor 13.

When such a system is used for the optical inspection of PCBs, it is normal to effect the optical inspection and subsequent marking in two distinct stages. As is known, during the first stage of optical inspection locations on the PCB which are seen either to be faulty or suspect are memorized and in the subsequent marking stage each of these locations is marked so as to permit subsequent manual inspection and, possibly, correction. Consequently, it is most important that the optical inspection system 14 and the marking station 26 are in correct registration. In practice, this is accomplished by ensuring that the PCB itself is in correct registration with both the inspection system 14 and the marking system 26. Such registration is accomplished by so controlling the passage of the PCB through the inspection system 14, that its leading edge is parallel to the scan line of the inspection station 14 whilst a side edge is maintained flush with an inner surface of the side frame 41. Such registration can be accomplished manually and, to this effect, there are provided registration pins 70 at a downstream end of the feeder 21 so that an operator can manually load the PCBs on to the feeder 21, when in its raised position, with the leading and side edges of the PCB respectively in contact with the registration pins 70 and the internal surface of the side frame 41.

Figs. 8a and 8b show schematically an end elevation of an alternative feeder 21 wherein the desired registration of the PCB 55 is effected automatically. As seen, the feeder 21 comprises a support surface depicted generally as 75 in the form of a plurality of spaced-apart rollers 76 disposed between adjacent conveyor belts 43. The rollers 76 are mounted on shafts 77 opposite ends of which are mounted within a support frame shown generally as 78 and which is operated by a suitable mechanism for raising and lowering into the positions shown in Figs. 8(a) and 8(b), respectively. Thus, in operation, the rollers 76 are first raised into the position shown in Fig. 8(a) wherein the supporting surface 75 of the feeder 21, constituted by the upper surface of each of the rollers 75, is proud of the upper surface of the conveyer belts 43. The PCB 55 is then released onto the feeder 21 as explained above and the rollers 76 are rotated in a clockwise direction (as shown in the figure) save thereby to convey the PCB 55 laterally towards the side frame 41. This having been done, the frame 78 is lowered into the position shown in Fig. 8(b), wherein the supporting surface 75 of the feeder 21 is beneath the supporting surface of the conveyor belts 43. By such means, the PCB 55 is transferred from the feeder 21 to the conveyer 13.

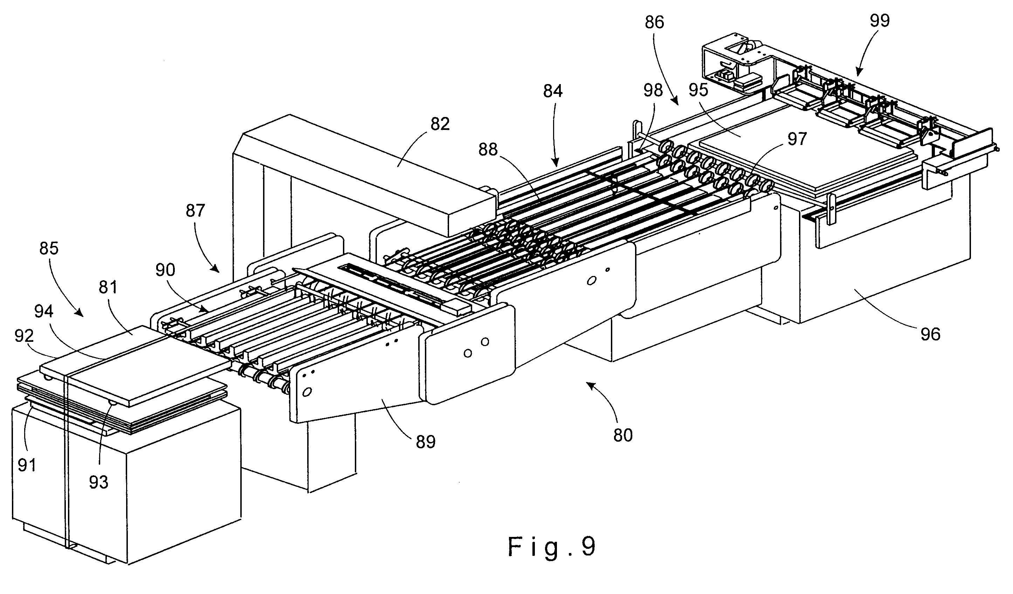

Referring now to Fig. 9 there is illustrated schematically a conveying system, generally designated 80, for conveying a stream of PCBs 81 to and through an optical inspection station 82, wherein a progressing PCB is processed without interrupting the flow of succeeding or preceding PCBs. The inspection station 82 allows for conventional inspection of PCBs using any of a number of conventional techniques for detecting flaws. Downstream of the inspection station 82 there is disposed an additional marking station 84 for marking locations of detected flaws, if any.

Since the inspection station 82 does not itself form a part of the present invention, details of its construction and operation are not set forth herein, except to note that PCBs 81 are inspected from above by suitable optical means adapted for scanning the PCB in order to locate defects. For example, a CCD Image Sensor LKI-6003 commercially available from Eastman Kodak Company may be employed.

The conveying system 80 includes a loader 85 and an unloader 86, and a main conveyor 87 extending between the loader 85 and the marking station 84 and adapted to transport loaded PCBs to and through the inspection station 82. This having been done, as inspected PCB is then further transported towards the marking station 84, associated with which is a separate conveyor table 88. The loader 85 may be of any known type, for example such as PCB Car. Automat MA 6095067 commercially available from Rescotron, Italy. The marking station 84 also employs a belt conveyor having a plurality of spaced apart belts which are slightly inclined toward tie side frame 41 so that as a PCB is conveyed through the marking station 84, a side edge of the PCB is maintained flush with an inner surface of the side frame 41 thereby maintaining correct registration of the PCB.

It should be noted that the provision of the conveyor table 88 is optional, to exemplify the most general case of processing workpieces at more than one working station. In the specific example of optical inspection of printed circuit boards having an artwork thereon, the conveyor table 88 is associated with a marking assembly, and comprises a conveying mechanism adapted to receive the inspected PCB from the main conveyor 87 and further transfer it towards the unloader 86, which will be described in more detail further below. The main conveyor 87 is enclosed between spaced parallel side frames 89 and operates to convey the loaded PCB in a conveying direction, shown by arrow $D_1$ in Fig. 9.

It will be appreciated that reliable scanning requires proper mounting of the progressing PCB on a working table, or other supporting surface, so as to ensure its precise positioning in a registration corner, and allow it to be perfectly guided relative to the supporting surface. As noted above, one of the particular features of the present invention is the provision of a feeder 90 installed upstream and downstream of the inspection station 82. The feeder 90 is provided with a registration means defining two registration shoulders at right-angles to each other which are engageable with a registration corner of the PCB in order to position it precisely for processing. Construction of the feeder 90 and its relationship with the main conveyor 87 is as described above with reference to Fig. 6a of the drawings.

Thus, the PCBs which are to be inspected are stacked and supported by a self-leveling supply table 91, which includes an automatic lifting mechanism for continuously raising the level of the stack so as to maintain the topmost PCB 82a at a predetermined vertical position wherein it is at the same level as the main conveyor 87. Also provided is a loading carriage 92 having a plurality of suction cups 93 for capturing the topmost PCB 82a from the stack 82 and being adjusted for sliding movement along a sliding rail 94 between the supply table 91 and the feeder 90.

It will be understood that the loader 85 may be of alternative construction, and may, for example, comprise additional conveying means adapted to receive the topmost PCB 82a from the table 91 and to transfer it on to the feeder 90.

A stack of inspected PCBs 95 is supported by a similar, self-leveling collecting table 96 which may either comprise a similar unloading carriage, or conveying and air cushion means. Alternatively, the collecting table 96 may include several selectively enabled conveying mechanisms for transporting the inspected PCBs in different directions according to corresponding sort criteria.

Preferably, the collecting table 96 is provided with a plurality of wheels 97 rotatably supported on a pin 98 in a spaced apart parallel relationship along its length, and a gripper assembly, generally designated 99. The pin 98 is disposed transverse to the conveying direction $D_1$ in which PCBs arrive on to the collecting table 96. The gripper assembly 99 is mounted for slidable movement above the surface of the table 96 in a direction towards and away from the wheels 97 parallel to the conveying direction $D_1$. The construction and operation of the gripper assembly 99 will be described more specifically below with reference to Figs. 10a to 10d of the drawings.

Also provided is a guiding mechanism generally denoted 100, which is supported by the side frames 89 of the main conveyor 87 and is adapted for guiding the advance of the PCBs in the conveying direction $D_1$ during processing. The guiding mechanism 100 is as described above with reference to Figs. 6a to 6c of the drawings.

The preferred embodiments have been described with particular reference to spaced apart conveyor belts interacting with the feeder means disposed between adjacent belts for lowering and raising a supporting surface thereof relative to a support surface of the conveyor belts. However, it is to be understood that the principles of the invention are equally applicable for use with a single conveyor belt conveying thereon workpieces which are themselves wider than the conveyor belt. Such workpieces may then be released on to and lifted off the conveyor belts by means of a feeder and transfer mechanism disposed on opposite sides of the conveyor belt.

## Claims

1. A method for continuously processing successive workpieces along a production line having a loading means for loading workpieces on to a conveying means for conveying through a processing means and an unloading means for unloading a processed workpiece,

   CHARACTERISED BY THE STEPS OF:

   (a) loading an operational workpiece on to a feed means,
   (b) transferring the operational workpiece from the feed means to the conveying means,

(c) conveying the operational workpiece through the processing means for performing a desired operation thereon,

(d) loading a successive workpiece on to the feed means,

(e) after said operation has been performed, unloading the operational workpiece from the conveying means, and

(f) repeating steps (b) to (e), as required, in respect of successive workpieces.

2. The method according to Claim 1, wherein the operational workpiece is loaded on to the feed means in a predetermined registration.

3. The method according to Claim 1, further including the step of:

registering the workpiece on the conveying means in a predetermined registration with respect to the conveying means upstream of the processing means.

4. The method according to Claim 1, further including the steps of:

registering the workpiece on the feed means in a predetermined registration with respect to the feed means, and

transferring the workpiece from the feed means to the conveying means whilst maintaining said predetermined registration.

5. A system (10) for continuously processing successive workpieces along a production line having a loading means (11) for loading workpieces (12) on to a conveying means (13) for conveying through a processing means (14) and an unloading means (15) for unloading a processed workpiece,

CHARACTERISED IN THAT:

(a) a feed means (21) independent of the conveying means receives a workpiece from the loading means without disturbing the conveying means, and

(b) a transfer means (63) is provided for transferring the operational workpiece from the feed means to the conveying means prior to processing of the workpiece, and

(c) the unloading means (15) is coupled to the conveying means for unloading the operational workpiece from the conveying means after processing so as to allow subsequent unloading without disturbing the conveying means.

6. The system according to Claim 5, wherein:

the feed means (21) includes a conveyor belt (43) extending between the loading and unloading means and defining a support surface (60) for supporting a workpiece thereon, and

the conveyor means (13) has an upper surface astride the feed means and having a gap therein for accommodating therein the support surface of the feed means when the conveyor means is elevated.

7. The system according to Claim 5, wherein:

the feed means includes at least two spaced apart conveyor belts extending between the loading and unloading means and each having a support surface for supporting a workpiece thereon, and

the conveyor means has an upper surface for protruding upwardly through respective gaps between adjacent conveyor belts of the feed means when the conveyor means is elevated.

8. The system according to Claim 6 or 7, wherein the transfer means is coupled to the conveying means and comprises:

lowering means for lowering an upper surface of the conveying means below the support surfaces of the feed means,

traction means (16) responsively coupled to the lowering means for transporting the conveying means to a location underneath the support surfaces of the feed means having a workpiece thereon, and

lifting means responsively coupled to the traction means for raising the upper surface of the conveying means above the support surfaces of the feed means between adjacent conveyor belts thereof so as lift the workpiece from the feed means on to the conveying means.

9. The system according to Claim 8, wherein:

the lowering means is coupled to the unloading means for lowering the upper surface of the conveying means below the support surfaces of the feed means so as to drop the processed workpiece from the conveying means on to the feed means.

10. The system according to Claim 5, wherein:

the conveyor means includes a conveyor belt extending between the loading and unloading means and having a support surface for supporting a workpiece thereon, and

the feed means has an upper surface astride the conveyor means and having a gap therein for accommodating therein the support surface of the conveyor means when the feed means is elevated.

11. The system according to Claim 5, wherein:

the conveyor means includes at least two spaced apart conveyor belts (43) extending between the loading and unloading means and each having a support surface for supporting a workpiece thereon, and
the feed means has an upper surface (60) protruding through respective gaps between adjacent conveyor belts.

12. The system according to Claim 10 or 11, wherein the transfer means is coupled to the feed means and includes:

lifting means (63) responsively coupled to a lifting signal for raising an upper surface of the feed means above the support surfaces of the conveyor means so as to receive a workpiece thereon form the loading means, and
means for lowering (63) the upper surface of the feed means beneath the support surfaces of the conveyor means so as drop the workpiece from the feed means on to the conveying means.

13. The system according to Claim 12, further including:

sensing means (23) for sensing when the operational workpiece has passed through the workstation so as to generate the lifting signal.

14. The system according to Claim 12, wherein the lifting signal is generated manually by an operator.

15. The system according to any one of Claims 12 to 14, wherein the unloading means (15) includes:

an unloading conveyor (31) downstream of the workstation (14) having upstream (32) and downstream rollers (33) for supporting a conveyor belt substantially level with the conveying means in overlapping spatial relationship with the conveying means (13), and
lifting means coupled to the upstream roller (32) and to the sensing means (23) and being responsive to the operational workpiece having passed through the workstation for raising the upstream roller so as to intercept the processed workpiece such that further movement of the conveying means transfers the processed workpiece on to the unloading conveyor.

16. The system according to Claim 10 or 11, wherein an internal surface of the or each conveying means is supported on an outer surface of a rotatable drum (30) having a respective recess for slidably accommodating therein the conveying means so that the workpiece is supported on an outer surface of the drum during processing.

17. The system according to Claim 16, further including a drive means coupled to a drive shaft (45) of the drum so that rotation of the drum produces translation of the conveying means.

18. The system according to Claim 6 or 7, wherein the feeder means further includes automatic registration means (70) for providing a precise positioning of the workpiece with respect to the feeder means.

19. The system according to Claim 19, wherein the automatic registration means includes means (76) for moving the workpiece laterally on the feeder means towards an edge thereof.

20. The system according to Claim 10 or 11, wherein the feeder means further includes automatic registration means for providing a precise positioning of the workpiece with respect to the feeder means.

21. The system according to Claim 20, wherein the automatic registration means includes means (76) for moving the workpiece laterally on the feeder means towards an edge thereof.

22. The system according to any one of Claims 5 to 21, wherein the workpiece is formed of planar sheet material and the workstation is an optical inspection system for inspecting possible flaws on an upper surface of said sheet material.

23. The system according to any one of Claims 10 to 22, wherein the workpiece is formed of planar sheet material and the workstation is an optical inspection system for inspecting possible flaws on an upper surface of said sheet material, the optical inspection system including:

a fixed imaging means for imaging the upper surface of the sheet material, and
a focussing means (46) for raising or lowering the surface of the conveying means in an area of the imaging means.

24. The system according to Claim 16 or 17, further comprising a focussing means including an eccentric drive means coupled to an eccentric drive shaft (46) of the drum (30) for vertically displacing the drum.

25. The system according to any one of Claims 10 to 24, wherein the workpiece is a printed circuit board having an artwork thereon.

26. The system according to Claim 25, further including a marking station (84) downstream of the inspection station (14, 82) for marking areas of the printed circuit board which require further processing.

27. The system according to Claim 26, wherein the marking station includes a belt conveyor (88) having a plurality of spaced apart belts which are slightly inclined toward a side frame of the marking station so that as the printed circuit board is conveyed through the marking station, a side edge of the printed circuit is maintained flush with an inner surface of the side frame thereby maintaining correct registration of the printed circuit board.

Fig. 1a

Fig. 1b

Fig. 1c

Fig. 1d

Fig. 1e

Fig. 1f

Fig.2a

To Fig.2b

From Fig. 2a

```
┌─────────────────────┐
│   LOWER CONVEYOR     │
│   TO RETURN PCB      │
│     TO FEEDER        │
└─────────────────────┘
          │
          ▼
┌─────────────────────┐
│ CONVEYOR RETURNS TO  │
│  BASE TO BE READY    │
│    FOR NEXT PCB      │
└─────────────────────┘
          │
          ▼
┌──────────────────────┐
│  INSPECTED PCB IS FED │
│ BY FEEDER TO UNLOADER │
│  AND NEXT PCB IS FED  │
│     TO CONVEYOR       │
└──────────────────────┘
          │
          ▼
      ⬭ REPEAT ⬭
```

Fig. 2 b

START

LOAD NEXT WORKPIECE
ON TO FEEDER

TRANSFER WORKPIECE
TO CONVEYOR

EFFECT PCB REGISTRATION

RETURN LOADER TO BASE
AND LOAD NEXT WORKPIECE

DISABLE FEEDER AND CONVEY
WORKPIECE FOR PROCESSING

HAS
WORKPIECE
PASSED THROUGH
PROCESSOR
?

N

Y

UNLOAD WORKPIECE FROM
CONVEYING MEANS

ENABLE FEEDER

MORE
WORKPIECES ?

N

N

END

Fig.3

Fig.4a

Fig.4b

Fig.4c

EP 0 855 856 A1

Fig. 4d

Fig. 4e

Fig. 4f

EP 0 855 856 A1

Fig. 4 h

Fig. 4 g

START

LOAD NEXT PCB ON TO LOADER

TRANSFER PCB ON TO FEEDER

RETURN LOADER TO BASE AND
LOAD NEXT PCB

FEEDER SENSES PCB

AUTOMATIC OR MANUAL REGISTRATION

FEEDER DROPS PCB ON TO
STATIONARY CONVEYOR

CONVEYOR CONVEYS PCB
FEEDER REMAINS LOW

HAS
PCB COMPLETELY
PASSED FEEDER
?

N

Y

RAISE FEEDER TO RECEIVE
NEXT PCB

To Fig. 5b

Fig. 5 a

From Fig. 5 a

Fig. 5 b

Fig.6a

Fig.6b

Fig.6c

Fig.7a

Fig.7b

Fig.7c

Fig.8a

Fig.8b

Fig. 9

**European Patent Office**

# EUROPEAN SEARCH REPORT

Application Number

EP 97 30 0521

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | EP 0 296 096 A (SIEMENS AKTIENGESELLSCHAFT BERLIN UND MÜNCHEN)<br>* column 4, line 23 - column 4, line 60; figure 1 *<br>--- | 1,2,4,5 | H05K13/00 |
| X | US 4 274 529 A (MORI ET AL.)<br>* column 2, line 64 - column 3, line 26; figures 2,4 *<br>--- | 1,2,5 | |
| X | PATENT ABSTRACTS OF JAPAN<br>vol. 10, no. 33 (M-452) [2090] , 8 February 1986<br>& JP 60 188232 A  (HITACHI SEISAKUSHO K.K.), 25 September 1985,<br>* abstract *<br>--- | 1,5 | |
| A | GB 2 155 910 A (USM CORPORATION)<br>* page 1, line 123 - page 3, line 63; figures 1,2 *<br>----- | 1,5-9 | |
| | | | TECHNICAL FIELDS SEARCHED (Int.Cl.6)<br><br>H05K<br>B65G<br>B65H |

The present search report has been drawn up for all claims

| Place of search | Date of completion of the search | Examiner |
|---|---|---|
| THE HAGUE | 27 June 1997 | Bolder, G |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)